(19) Europäisches Patentamt / European Patent Office / Office européen des brevets

(11) **EP 4 160 230 B1**

(12) **FASCICULE DE BREVET EUROPEEN**

(45) Date de publication et mention de la délivrance du brevet:
**22.01.2025 Bulletin 2025/04**

(21) Numéro de dépôt: **22194390.5**

(22) Date de dépôt: **07.09.2022**

(51) Classification Internationale des Brevets (IPC):
***G01R 31/11*** *(2006.01)*

(52) Classification Coopérative des Brevets (CPC):
**G01R 31/11**

(54) **MÉTHODE DE GÉNÉRATION D'UN SIGNAL DE RÉFLECTOMÉTRIE MULTIPORTEUSES AYANT LA FORME D'UN SIGNAL DE TYPE "CHIRP"**

METHODE ZUR ERZEUGUNG EINES MEHRTRÄGER-REFLEKTOMETRIESIGNALS, DAS DIE FORM EINES CHIRP-SIGNALS HAT

METHOD FOR GENERATING A MULTICARRIER REFLECTOMETRY SIGNAL IN THE FORM OF A CHIRP SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.09.2021 FR 2110241**

(43) Date de publication de la demande:
**05.04.2023 Bulletin 2023/14**

(73) Titulaire: **Commissariat à l'Energie Atomique et aux Energies Alternatives
75015 Paris (FR)**

(72) Inventeur: **YOSRA, Gargouri
91191 Gif-sur-Yvette Cedex (FR)**

(74) Mandataire: **Atout PI Laplace
Immeuble Up On
25 Boulevard Romain Rolland
CS 40072
75685 Paris Cedex 14 (FR)**

(56) Documents cités:
**FR-A1- 3 097 971**

• LAYER CHRISTOPHE ET AL: "Using quadrature modulation for precise fault location over wired communication channels", 2017 15TH IEEE INTERNATIONAL NEW CIRCUITS AND SYSTEMS CONFERENCE (NEWCAS), IEEE, 25 June 2017 (2017-06-25), pages 357 - 360, XP033141975, DOI: 10.1109/NEWCAS.2017.8010179
• AJAMIAN TZILA ET AL: "Compressed signal acquisition in wire diagnostic", 2017 IEEE SENSORS, IEEE, 29 October 2017 (2017-10-29), pages 1 - 3, XP033281249, DOI: 10.1109/ICSENS.2017.8234017

**Description**

L'invention concerne le domaine des systèmes de diagnostic filaires basés sur le principe de la réflectométrie pour identifier et caractériser des défauts électriques sur des câbles ou plus généralement des lignes de transmission. L'invention concerne plus précisément le domaine de la réflectométrie multi-porteuses OMTDR (Orthogonal Multi-Tone Time Domain Reflectometry) qui utilise des signaux multi-porteuses générés à partir du principe de modulation OFDM (Orthogonal Frequency Division Multiplexing).

L'invention vise à proposer une méthode pour générer un signal de réflectométrie OMTDR ayant une forme de signal « chirp », un tel signal présentant des propriétés avantageuses en termes de rapport entre puissance crête et puissance moyenne et en termes de compressibilité, ce signal ayant un caractère parcimonieux.

Les câbles sont omniprésents dans tous les systèmes électriques, pour l'alimentation ou la transmission d'information. Ces câbles sont soumis à des contraintes et peuvent être sujets à des défaillances. Il est donc nécessaire de pouvoir analyser leur état et d'apporter des informations sur la détection de défauts qui impactent ces câbles, ces informations incluant l'existence de défauts mais aussi leur localisation et leur type. L'analyse de défauts permet d'aider à la maintenance des câbles. Les méthodes de réflectométrie usuelles permettent ce type d'analyse.

Les méthodes de réflectométrie utilisent un principe proche de celui du radar : un signal électrique, le signal de sonde ou signal de référence, est injecté en un ou plusieurs endroits du câble à tester. Le signal se propage dans le câble ou le réseau de câbles et renvoie une partie de son énergie lorsqu'il rencontre une discontinuité d'impédance. Une discontinuité d'impédance peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

La réflectométrie MCR (« MultiCarrier Reflectometry ») utilise des signaux multi-porteuses. Son intérêt est la grande flexibilité avec laquelle on peut moduler le spectre du signal émis, ce qui permet ainsi de s'adapter à des contraintes propres au diagnostic en ligne. Par exemple, s'il est interdit d'émettre sur une bande de fréquence située au milieu du spectre du signal test, il est tout à fait possible d'annuler l'énergie du signal sur cette bande de fréquences. On connaît également la réflectométrie MCTDR (« MultiCarrier Time Domain Reflectometry »), comme décrit dans le document référencé [1].

La réflectométrie OMTDR (« Orthogonal Multi-tone Time Domain Reflectometry ») qui est basée sur le principe de l'OFDM, utilise un signal multi-porteuses (comme pour la réflectométrie MCTDR), mais en ajoutant une modulation, par exemple une modulation de phase PSK ou de phase et d'amplitude QAM au signal à émettre. Ainsi les signaux OMTDR permettent à la fois de diagnostiquer des défauts dans un câble mais également de transmettre de l'information via le signal modulé.

L'invention entre dans le champ d'application des méthodes de diagnostic filaire par réflectométrie et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Un premier problème à résoudre dans un système de diagnostic filaire concerne l'atténuation que subit le signal injecté dans le câble à analyser, lorsqu'il se propage le long de ce câble jusqu'à rencontrer un défaut provoquant une réflexion. Le pic de réflexion est usuellement déterminé par inter-corrélation entre le signal injecté et le signal réfléchi. Lorsque le câble est long par rapport à la longueur d'onde du signal, celui-ci subit une atténuation lors de sa propagation et de sa rétro-propagation, qui est fonction de la distance parcourue par le signal. Cette atténuation présente un inconvénient majeur lors de l'étape d'analyse des signaux réfléchis, par réflectométrie temporelle, qui vise à identifier un pic d'amplitude dans le résultat de l'intercorrélation entre le signal émis et le signal réfléchi. En effet, plus le signal est atténué, plus il est difficile de détecter la signature d'un défaut dans la mesure du signal réfléchi. Ceci est d'autant plus vrai que le défaut visé est un défaut non franc, c'est-à-dire qui correspond à une faible variation d'impédance, c'est-à-dire un défaut superficiel.

Pour limiter l'atténuation du signal lors de sa propagation dans un câble, il est donc souhaitable d'utiliser un amplificateur pour amplifier le signal avant son injection, afin de compenser les effets de l'atténuation.

Cependant, les amplificateurs de signaux ont un comportement non-linéaire qui entraine une saturation des valeurs élevées du signal à amplifier. Ce comportement non-linéaire est d'autant plus présent que le signal à amplifier présente un rapport entre puissance crête et puissance moyenne (ou PAPR pour Peak to Average Power Ratio) élevé. C'est le cas des signaux multi-porteuses comme les signaux OFDM (Orthogonal Frequency Division Multiplexing), ou les signaux spécifiquement dédiés à la réflectométrie tels que les signaux MCTDR (Multi-Carrier Time Domain Reflectometry) ou OMTDR (Orthogonal Multi-tone Time Domain Reflectometry) qui sont basés sur le principe de l'OFDM.

Ce comportement non linéaire dégrade le rapport signal sur bruit des mesures réalisées ce qui produit un effet néfaste sur la précision de la détection des défauts, voire une non détection de défauts dans certains cas, en particulier pour le cas de défauts non francs.

Il existe donc un besoin pour réduire ou limiter la puissance crête de signaux multi-porteuses destinés à être utilisés par un système de réflectométrie.

Un second problème à résoudre concerne l'élargissement de la bande spectrale du signal qui est directement liée à la résolution spatiale avec laquelle un défaut peut être détecté. Autrement dit, plus la bande de fréquence du signal est élevée plus il est possible de localiser précisément un défaut, même de très petite dimension. Or, un système de réflectométrie est limité par la fréquence d'échantillonnage du convertisseur analogique numérique. En effet, plus cette fréquence est élevée, plus le convertisseur est couteux à implémenter, plus il consomme d'énergie et plus son niveau de bruit est élevé. Par ailleurs, il n'est, en théorie, pas possible d'échantillonner correctement un signal ayant une fréquence supérieure à la fréquence d'échantillonnage (théorème de Nyquist).

Une solution pour pallier ce problème et pour utiliser des signaux large bande tout en conservant un convertisseur analogique numérique à fréquence d'échantillonnage limitée, consiste à utiliser des signaux parcimonieux qui sont naturellement compressibles dans un domaine particulier défini par une base de données, par exemple dans le domaine temporel, fréquentiel ou temps-fréquence et qui permettent de réaliser un échantillonnage comprimé à une fréquence d'échantillonnage inférieure à la fréquence maximale du signal. Cependant, les signaux OMTDR sont, par nature, non parcimonieux et ne sont donc pas compressibles.

Un objectif de l'invention est de résoudre les problèmes précités pour concevoir des signaux de réflectométrie OMTDR qui soient parcimonieux et qui ont un facteur crête réduit.

La demande de brevet FR3097971 du Demandeur décrit une méthode de génération d'un signal OMTDR ayant un rapport entre puissance crête et puissance moyenne réduit par rapport à un signal OMTDR classique. La méthode est basée sur une réservation de sous-porteuses. Elle présente les inconvénients suivants : elle nécessite une adaptation de la chaîne d'émission par ajout de traitements supplémentaires pour modifier la structure du signal ce qui complexifie la méthode. Par ailleurs, le signal obtenu n'est pas parcimonieux et donc n'est pas compressible. Il ne permet pas un fonctionnement avec un convertisseur analogique numérique de fréquence d'échantillonnage réduite.

La publication [1] décrit une méthode de réflectométrie MCTDR comprenant un système d'acquisition comprimée qui permet de réduire la fréquence d'échantillonnage du convertisseur analogique numérique à une fréquence inférieure à la fréquence maximale du signal. Cependant la méthode décrite n'est pas compatible d'un signal OMTDR.

La publication « Using quadrature modulation for precise fault location over wired communication channels » de Christophe Layer et al, 2017 15th IEEE International new circuits an systems conférence décrit une autre méthode connue de réflectométrie.

L'invention propose une nouvelle méthode de génération d'un signal OMTDR optimisé dans lequel les phases des symboles modulés sont déterminées selon une loi de distribution particulière qui a pour effet de modifier la forme du signal pour qu'il soit du type d'un signal « chirp ».

Un signal « chirp » est un signal sinusoïdal à fréquence variable. Autrement dit, il s'agit d'un signal pseudo-périodique modulé en fréquence avec une fréquence qui évolue dans le temps selon une loi d'évolution prédéterminée, par exemple une loi d'évolution linéaire ou logarithmique. Par construction, un signal « chirp » possède une structure parcimonieuse dans le plan temps-fréquence et présente également un facteur crête réduit.

Ainsi, l'invention permet de générer un signal OMTDR ayant la forme d'un signal « chirp » ce qui permet de résoudre les problèmes identifiés ci-dessus.

L'invention a pour objet une méthode de génération d'un signal de réflectométrie multi-porteuses destiné à être injecté dans une ligne de transmission pour identifier la présence d'au moins un défaut éventuel sur la ligne, la méthode comprenant les étapes de :

- Générer, dans le domaine fréquentiel, un signal numérique multi-porteuses modulé en phase en :

    i. Générant un signal numérique,

    ii. Modulant le signal numérique en phase à partir d'une constellation de symboles, la phase $\theta_k$ de chaque symbole modulé étant déterminée à partir de l'égalité suivante : $\theta_k = \pm(\alpha * k^2)$, où k est l'indice de chaque porteuse du signal et varie entre 1 et le nombre de porteuses N du signal,

    iii. $\alpha$ est un coefficient pris dans l'intervalle $[\frac{\pi}{N} - \frac{\pi}{2N} ; \frac{\pi}{N} + \frac{\pi}{2N}]$,

    iv. Arrondissant la phase $\theta_k$ obtenue à la phase du symbole de la constellation la plus proche,

- Convertir le signal généré dans le domaine temporel.

Selon un aspect particulier de l'invention, la phase $\theta_k$ de chaque symbole modulé est déterminée à partir de l'égalité suivante; $\theta_k = \pm(\alpha * k^2) + \gamma \frac{\pi}{N} k + \delta$ , où $\gamma$ est un entier relatif et $\delta$ est une constante.

Selon un aspect particulier de l'invention, la constellation de symboles est une constellation d'une modulation en phase PSK ou d'une modulation en phase et en amplitude QAM.

Selon un aspect particulier de l'invention, le signal généré est un signal pseudo-périodique modulé en fréquence de type « chirp ».

Dans une variante de réalisation, la méthode selon l'invention comprend en outre les étapes de :

- Convertir le signal numérique généré en signal analogique,

- Injecter le signal analogique dans une ligne de transmission.

L'invention a encore pour objet une méthode d'identification de la présence d'au moins un défaut éventuel sur une ligne de transmission, la méthode comprenant les étapes de :

- Générer un signal de réflectométrie multi-porteuses et l'injecter dans une ligne de transmission au moyen de la méthode selon l'invention,

- Acquérir et analyser l'écho dudit signal de réflectométrie réfléchi pour en déduire une information relative à la détection et/ou la localisation de discontinuité d'impédance caractéristique d'au moins un défaut.

Selon un aspect particulier de l'invention, l'étape d'analyser l'écho du signal de réflectométrie comprend les sous-étapes de :

- calculer l'intercorrélation entre le signal de réflectométrie réfléchi et le signal de réflectométrie injecté dans la ligne, pour obtenir un réflectogramme,

- analyser le réflectogramme pour identifier au moins un pic d'amplitude caractéristique de la présence d'un défaut sur la ligne.

Selon un aspect particulier de l'invention, l'étape d'analyser l'écho du signal de réflectométrie comprend les sous-étapes de :

- Multiplier le signal de réflectométrie acquis par une séquence pseudo aléatoire,

- Appliquer un filtre passe bas au signal obtenu,

- Convertir le signal filtré numériquement,

- Reconstruire le signal

L'invention a encore pour objet un programme d'ordinateur comportant des instructions pour l'exécution de la méthode de génération d'un signal de réflectométrie selon l'invention, lorsque le programme est exécuté par un processeur.

L'invention a encore pour objet un support d'enregistrement lisible par un processeur sur lequel est enregistré un programme comportant des instructions pour l'exécution de la méthode de génération d'un signal de réflectométrie selon l'invention, lorsque le programme est exécuté par un processeur.

L'invention a encore pour objet un dispositif de génération d'un signal de réflectométrie destiné à être injecté dans une ligne de transmission pour identifier la présence d'au moins un défaut éventuel sur la ligne, ledit dispositif comprenant des moyens adaptés pour mettre en oeuvre la méthode de génération d'un signal de réflectométrie selon l'invention.

Le dispositif selon l'invention peut comprendre un générateur de signal de réflectométrie configuré pour mettre en oeuvre la méthode de génération d'un signal de réflectométrie selon l'invention, un convertisseur numérique analogique (CNA) et un dispositif de couplage pour injecter le signal de réflectométrie analogique dans une ligne de transmission.

D'autres caractéristiques et avantages de la présente invention apparaîtront mieux à la lecture de la description qui suit en relation aux dessins annexés suivants.

La Fig. 1 représente un schéma illustrant le principe connu de la réflectométrie temporelle et son application à la détection d'un défaut non franc,

La Fig. 2 représente un exemple de deux réflectogrammes illustrant l'allure de la signature d'un défaut non franc, l'un obtenu en injectant un signal ayant des composantes à hautes fréquences, l'autre en injectant un signal ayant des composantes à basses fréquences,

La Fig. 3 représente un schéma d'un système de réflectométrie OMTDR selon l'art antérieur,

La Fig. 4 illustre, sur plusieurs diagrammes, les caractéristiques d'un signal OMTDR selon l'art antérieur,

La Fig. 5 représente un organigramme détaillant les étapes de mise en oeuvre de la méthode de génération d'un signal OMTDR optimisé selon un mode de réalisation de l'invention,

La Fig. 6 représente deux diagrammes de constellations de symboles modulés en phase correspondant à deux étapes différentes de l'invention,

La Fig. 7 illustre, sur plusieurs diagrammes, les caractéristiques d'un exemple de signal OMTDR obtenu à l'aide de la méthode selon l'invention,

La Fig. 8 représente un réflectogramme comparatif illustrant les résultats obtenus avec un signal OMTDR classique et un signal OMTDR généré avec l'invention,

La Fig. 9 représente, sur plusieurs diagrammes, certaines caractéristiques d'un signal OMTDR classique permettant d'évaluer sa compressibilité.

La Fig. 10 représente les mêmes diagrammes qu'à la figure 9 mais pour un signal OMTDR obtenu à partir d'un mode de réalisation de l'invention,

La Fig. 11 représente un schéma d'un système de réflectométrie à acquisition compressée selon un second mode de réalisation de l'invention.

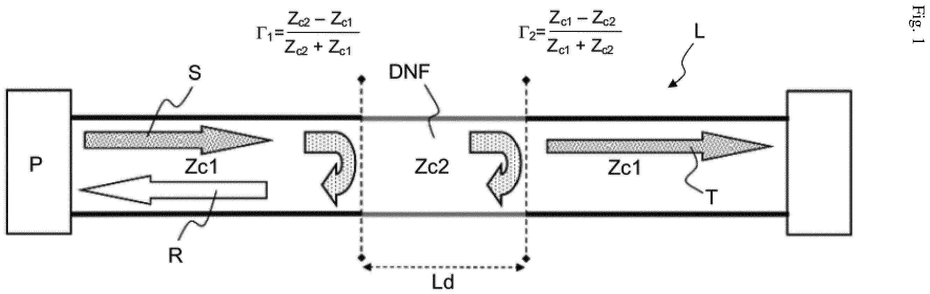

La figure 1 schématise, pour rappel, le principe de fonctionnement d'une méthode de diagnostic par réflectométrie appliquée à une ligne de transmission L présentant un défaut non-franc DNF. L'exemple décrit ci-dessous correspond à une méthode de réflectométrie temporelle.

Un signal de référence S est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut non franc DNF. Le signal se réfléchit sur cette discontinuité avec un coefficient de réflexion $\Gamma_1$. Si l'impédance caractéristique $Z_{c2}$ dans la zone du défaut non franc DNF est inférieure à l'impédance caractéristique $Z_{c1}$ avant l'apparition du défaut, alors le coefficient de réflexion $\Gamma_1$ est négatif et se traduit par un pic d'amplitude négative dans le signal réfléchi R. Dans le cas inverse, le coefficient de réflexion $\Gamma_1$ est positif et se traduit par un pic d'amplitude positive dans le signal réfléchi R.

La partie transmise T du signal incident S continue de se propager dans la ligne et rencontre ensuite une deuxième discontinuité d'impédance créant une deuxième réflexion du signal incident avec un coefficient de réflexion $\Gamma_2$ de signe opposé au premier coefficient de réflexion $\Gamma_1$. Si $\Gamma_1 < 0$ alors $\Gamma_2 > 0$. Si $\Gamma_1 > 0$ alors $\Gamma_2 < 0$.

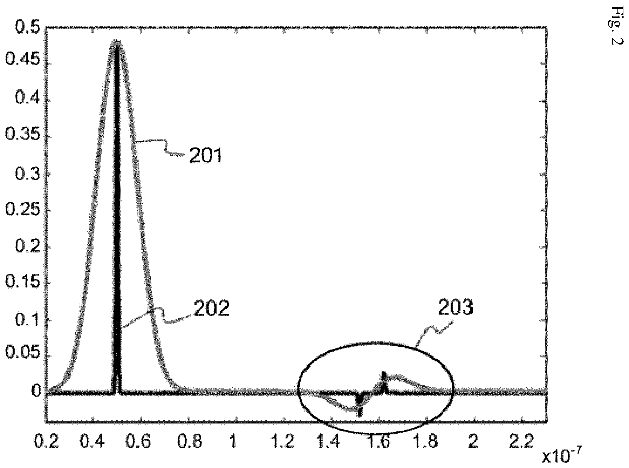

Ainsi, en observant le signal réfléchi R, la signature du défaut non franc DNF est caractérisée par deux pics successifs de signes inversés comme le montre la figure 2.

La figure 2 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, ce qui correspond au cas d'une méthode de réflectométrie temporelle, le réflectogramme peut correspondre directement à la mesure du signal réfléchi R. Dans le cas où le signal de référence injecté est un signal plus complexe, par exemple pour des méthodes de type MCTDR (Multi Carrier Time Domain Reflectometry) ou OMTDR (Orthogonal Multi tone Time Domain Reflectometry), alors le réflectogramme est obtenu en inter-corrélant le signal réfléchi R et le signal injecté S.

Sur la figure 2, on a représenté deux réflectogrammes 201,202 correspondants à des signaux ayant respectivement deux fréquences maximum différentes. La courbe 201 correspond à une durée d'impulsion 2.ΔT très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion 2.ΔT très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

Comme cela est connu dans le domaine des méthodes de diagnostic par réflectométrie, la position $d_{DNF}$ du défaut non franc sur le câble, autrement dit sa distance au point P d'injection du signal, peut être directement obtenue à partir de la mesure, sur le réflectogramme temporel de la figure 2, de la durée $t_{DNF}$ entre le premier pic d'amplitude relevé sur le réflectogramme (à l'abscisse 0,5 sur l'exemple de la figure 2) et le pic d'amplitude 203 correspondant à la signature du défaut non franc.

Différentes méthodes connues sont envisageables pour déterminer la position $D_{DNF}$. Une première méthode consiste à appliquer la relation liant distance et temps : $d_{DNF} = V.t_{DNF}/2$ où V est la vitesse de propagation du signal dans le câble. Une autre méthode possible consiste à appliquer une relation de proportionnalité du type $d_{DNF}/t_{DNF} = L/t_0$ où L est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

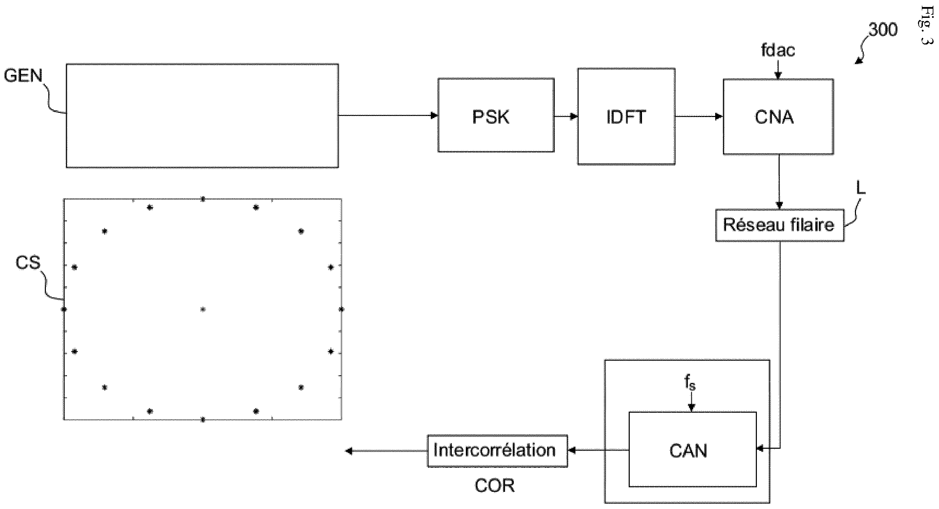

La figure 3 représente un schéma d'un système 300 d'analyse de défaut dans une ligne de transmission L, telle qu'un câble ou un réseau filaire, mettant en oeuvre une méthode de réflectométrie OMTDR selon l'art antérieur.

Un tel système 300 comprend un générateur GEN d'un signal de référence numérique. Le signal est modulé via un modulateur de phase MOD selon une modulation PSK (phase shift keying). La modulation PSK est associée à une constellation de symboles CS. Sur l'exemple de la figure 3, on a représenté une constellation d'une modulation 16PSK. Les bits du signal numérique sont associés aléatoirement aux symboles de la constellation PSK. Autrement dit, les symboles modulés sont, par exemple, générés directement aléatoirement pour construire le signal numérique modulé. Le signal modulé est ensuite synthétisé dans le domaine temporel au moyen d'un module IDFT de transformée de Fourier discrète inverse. Le signal synthétisé est ensuite converti analogiquement via un convertisseur numérique-analogique CNA puis est injecté en un point de la ligne de transmission L au moyen d'un coupleur ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit sur la discontinuité d'impédance provoquée par le défaut. Le signal réfléchi est rétro-propagé jusqu'à un point de mesure, qui peut être commun au point d'injection ou différent. Le signal rétro-propagé est converti numériquement par un convertisseur analogique numérique CAN. Une corrélation COR est ensuite effectuée entre le signal numérique mesuré et une copie du signal numérique généré avant injection afin de produire un réflectogramme temporel R(t) correspondant à l'inter-corrélation entre les deux signaux.

Un signal OMTDR est basé sur la technologie OFDM et consiste à utiliser des sous porteuses fréquentielles orthogonales entre elles pour former le signal de test.

Chaque amplitude, phase ou fréquence sert à encoder un certain nombre de bits appelé symbole. Les données binaires peuvent être aléatoires ou véhiculer un message d'information.

L'amplitude et la phase d'une sous-porteuse OFDM sont fixées par les données binaires à transmettre conformément au type de modulation choisi (M-PSK ou M-QAM).

Un exemple de modulation possible pour un signal OMTDR est la modulation M-PSK car elle présente de bonnes propriétés d'autocorrélation du fait que le spectre du signal est plat.

Dans une modulation par décalage de phase (M-PSK), M est l'ordre de la modulation (4 pour Q-PSK, 8 pour 8-PSK, 16 pour 16-PSK etc.) et chaque sous-porteuse $S_k$ est définie par son amplitude et sa phase de la façon suivante :

$$|s_k| = 1 \ \forall \ f_n \ et \ \phi(k) = \phi_n = i\frac{2\pi}{M}$$

où i est compris entre 0 et M - 1.

Comme pour toute technique de modulation numérique, la phase en question ne peut prendre qu'un nombre fini de valeurs. Chacune des valeurs de la phase représente un unique nombre binaire (appelé aussi symbole), dont la taille (et donc la quantité d'information transmise) dépend du nombre de valeurs possibles pour la phase. Généralement, pour une modulation PSK donnée, les nombres binaires représentés sont tous de même taille.

Par exemple, pour une modulation 8-PSK, la suite des données numériques à envoyer : 000 001 011 010 101 correspond à la suite des symboles : 5 4 3 2 7 et à la suite des phases $5\pi/8, 4\pi/8, 3\pi/8, 2\pi/8, 7\pi/8$, selon un exemple d'implémentation.

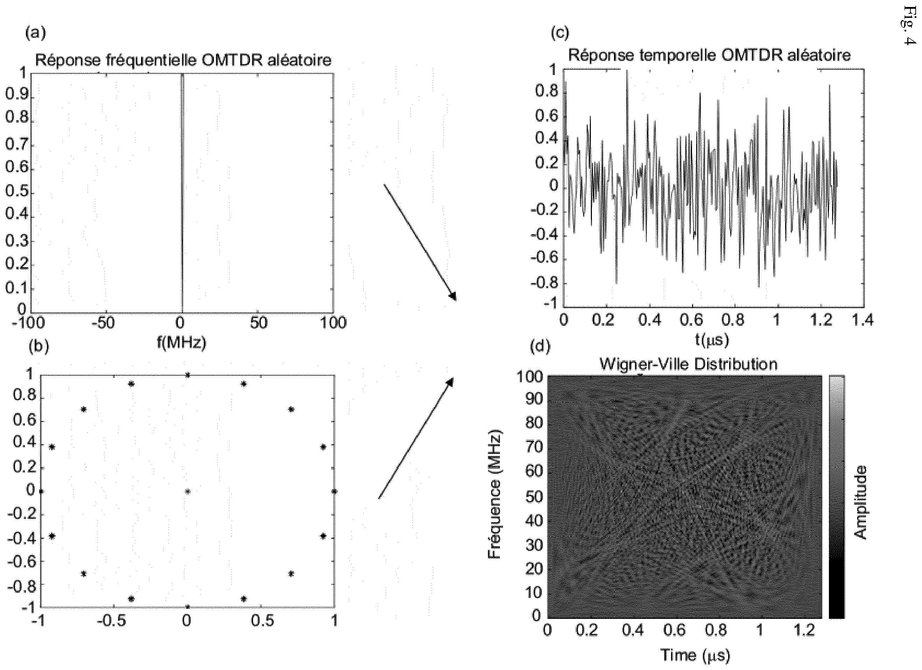

Un signal OMTDR avec des symboles (et donc des phases) choisies aléatoirement présente généralement un mauvais rapport entre puissance crête et puissance moyenne PAPR. Par ailleurs un tel signal est non compressible dans le plan temporel, fréquentiel et temps-fréquence comme illustré sur la figure 4.

Les diagrammes de la figure 4 représentent différentes caractéristiques d'un signal OMTDR classique modulé avec une modulation 16-PSK.

Les figures 4a) et 4b) correspondent respectivement au module de la réponse fréquentielle du signal et au diagramme de constellation 16-PSK du signal avec des phases générées aléatoirement.

La figure 4c) représente la réponse temporelle du signal et la figure 4d) représente la distribution du signal dans le plan temps fréquence, obtenu en appliquant une transformée de Wigner-Ville au signal.

On remarque que le signal est dense dans le plan temps fréquence, autrement dit qu'il n'est pas parcimonieux. Un tel signal n'est donc pas compressible.

L'invention vise à proposer une nouvelle méthode de génération d'un signal OMTDR qui permette de construire un signal ayant une forme de « chirp » tout en respectant les contraintes de la modulation adoptée.

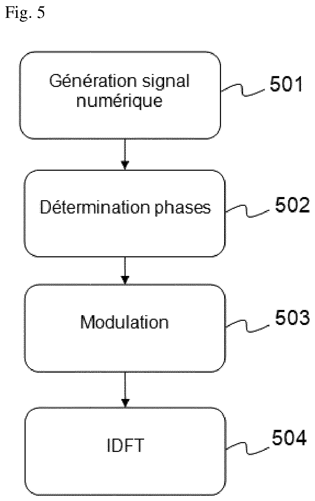

La figure 5 schématise, sur un organigramme, les étapes de mise en oeuvre de la méthode selon l'invention pour un exemple dans lequel la modulation utilisée est une modulation MPSK.

A l'étape 501, un signal numérique sous forme d'une séquence de bits est généré.

Le signal numérique est modulé par une modulation MPSK en associant chaque symbole numérique a un point de constellation MPSK.

Pour cela, à l'étape 502, on détermine, pour chaque symbole à moduler, une phase, à l'aide de l'expression suivante :

$$\theta_k = \pm(\alpha * k^2) + \gamma \frac{\pi}{N} k + \delta \quad (1)$$

k est l'indice d'une porteuse du signal, k variant de 1 à N avec N le nombre de sous-porteuses.

$\alpha$ est un coefficient pris dans l'intervalle $\left[\frac{\pi}{N} - \beta; \frac{\pi}{N} + \beta\right]$, avec $\beta = \frac{\pi}{2N}$

$\gamma$ est un nombre réel positif, négatif ou nul,

$\delta$ est une constante.

La relation (1) a notamment pour effet de générer un signal ayant la structure d'un signal « chirp ».

Cependant, les phases ainsi générées ne correspondent pas forcément à des symboles de la constellation MPSK choisie.

A l'étape 503, les phases générées à l'étape 502 sont arrondies aux phases des symboles de la constellation MPSK les plus proches.

Enfin à l'étape 504, une étape de transformée de Fourier discrète inverse est appliquée pour générer le signal OMTDR.

Le choix du coefficient $\alpha$ permet de structurer le signal pour qu'il ait la forme d'un signal chirp. En particulier, un coefficient $\alpha$ choisi au voisinage de $\frac{\pi}{N}$, par exemple dans l'intervalle $\left[\frac{\pi}{N} - \beta; \frac{\pi}{N} + \beta\right]$, avec $\beta = \frac{\pi}{2N}$ permet d'obtenir un signal ayant une forme de signal chirp tout en minimisant le facteur crête (PAPR).

Les coefficients $\gamma$ et $\delta$ influent sur la réduction du facteur crête (PAPR) du signal.

Selon un premier exemple de réalisation de l'invention, le coefficient $\alpha$ est pris égal à $-\frac{\pi}{N}$, le coefficient $\gamma$ est pris égal à 1 et le coefficient $\delta$ est pris égal à 0.

Autrement dit, dans cet exemple, les phases sont générées à l'aide de la relation :

$$\theta_k = -\frac{\pi}{N} k^2 + \frac{\pi}{N} k \quad (2)$$

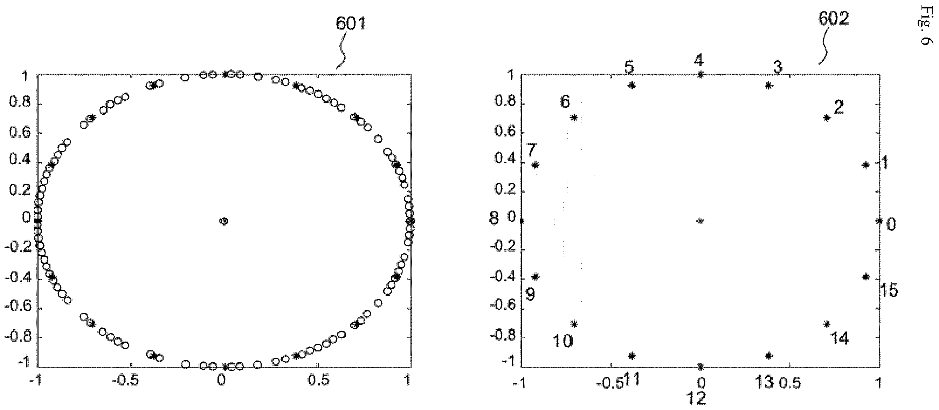

La figure 6 illustre, sur le diagramme de phases 601, les phases générées à l'aide de la relation (2) (étape 502) et sur le diagramme 602, les symboles de la constellation 16 PSK obtenus en arrondissant les phases du diagramme 601.

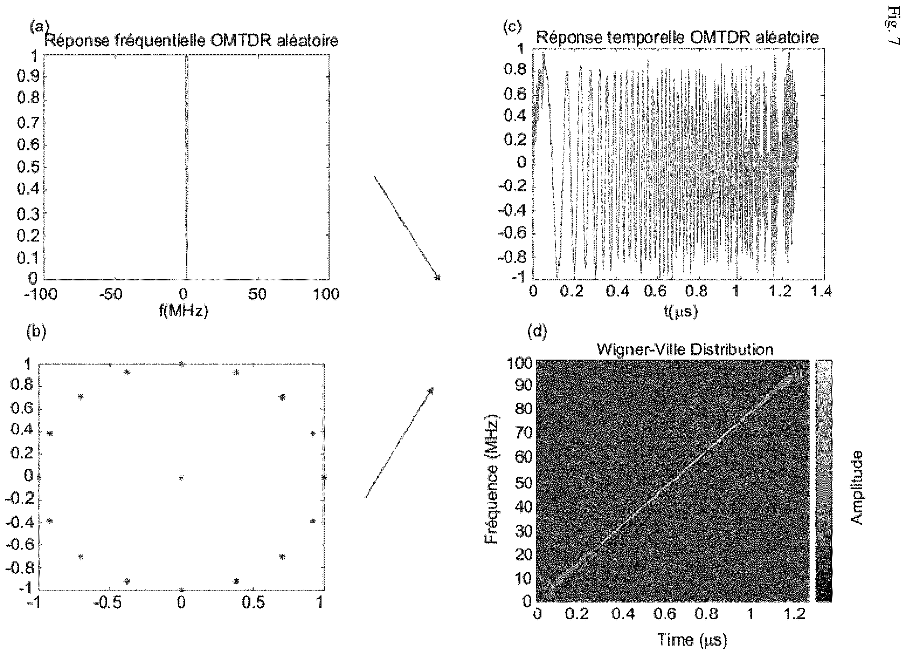

La figure 7 représente, sur les mêmes diagrammes qu'à la figure 4, les caractéristiques du signal OMTDR obtenus avec le premier exemple de réalisation de l'invention ci-dessus.

On remarque que la représentation du signal dans le plan temps fréquence (diagramme d)) suit une évolution linéaire qui est caractéristique d'un signal de type chirp. Cette propriété permet d'obtenir un signal parcimonieux et donc compressible et qui présente un facteur crête PAPR réduit.

A titre d'illustration, le tableau 1 suivant représente des exemples de résultats de rapport entre puissance crête et puissance moyenne (PAPR) pour différentes modulations PSK et différents nombres N de porteuses, pour un signal OMTDR classique.

| Nombre de points / Constellation | 256 | 512 | 1024 |
|---|---|---|---|
| 32 | 9.81 Db | 10.46 dB | 10.88 dB |
| 16 | 9.74 dB | 10.10 dB | 10.91 dB |
| 8 | 9.52 dB | 10.17 dB | 10.96 dB |
| 4 | 9.27 dB | 10.74 dB | 11.14 dB |

## Tableau 1

Le tableau 2 suivant représente les mêmes résultats pour un signal OMTDR obtenu avec le premier exemple de réalisation de l'invention.

| Nombre de points / Constellation | 256 | 512 | 1024 |
|---|---|---|---|
| 32 | 4.11 dB | 3.94 dB | 3.65 dB |
| 16 | 3.9 dB | 4.68 dB | 4.3 dB |
| 8 | 4.91 dB | 5.46 dB | 6.64 dB |
| 4 | 8.31 dB | 7.33 dB | 7.22 dB |

## Tableau 2

On voit que le facteur crête PAPR est fortement réduit grâce à l'invention.

D'autres exemples de loi de détermination de phases permettent d'obtenir les mêmes effets techniques, par exemple les lois suivantes :

$$\theta_k = \frac{\pi}{N}k^2 - 2\frac{\pi}{N}k + \frac{\pi}{N}$$

$$\theta_k = -\frac{\pi}{N}k^2$$

$$\theta_k = \frac{\pi}{N}k^2 + \frac{\pi}{N}$$

$$\theta_k = \frac{\pi}{N-1}k^2 - \frac{3\pi}{N-1}k + \frac{2\pi}{N-1}$$

L'invention est applicable aux modulations en phase M-PSK mais également aux modulations en phase et amplitude M-QAM.

Selon un premier mode de réalisation, l'invention peut être mise en oeuvre au moyen du dispositif de la figure 1, le générateur de signal numérique OMTDR étant remplacé par un générateur configuré pour exécuter la méthode de construction d'un signal OMTDR modifié selon l'invention.

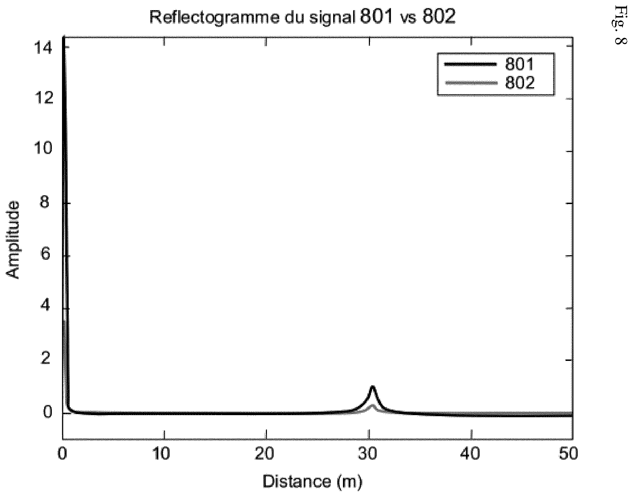

La figure 8 représente deux exemples de réflectogrammes 801,802 respectivement obtenus avec un système OMTDR de l'art antérieur et un système OMTDR selon le premier mode de réalisation de l'invention.

Dans ces deux exemples, un défaut électrique est situé à une distance de 30 m du point d'injection du signal. Ce défaut est caractérisé par un pic 803 dans le réflectogramme mesuré. On peut voir sur la figure 8, que le signal OMTDR amélioré selon l'invention permet d'amplifier le pic 803 par rapport au signal OMTDR classique. Du fait de l'amélioration du facteur crête PAPR du signal, le gain de détection du pic 803 est amélioré.

L'invention permet ainsi de réduire le rapport entre puissance crête et puissance moyenne d'un signal OMTDR afin d'améliorer la précision de détection de défauts par analyse d'un réflectogramme.

L'invention permet également de rendre un signal OMTDR parcimonieux et compressible dans le domaine temps fréquence.

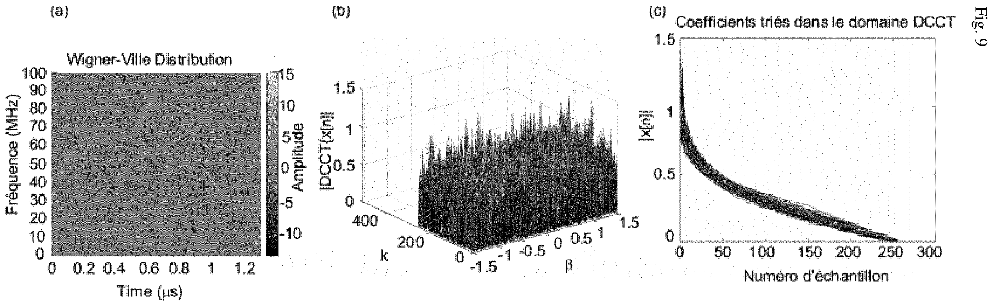

La figure 9 illustre, sur trois diagrammes, le fait qu'un signal OMTDR classique avec génération aléatoire des symboles modulés n'est pas parcimonieux ni compressible.

Un signal est compressible dans un domaine si les modules de ses coefficients triés dans ce domaine décroissent rapidement. Par la suite, on considère le domaine de la transformée DCCT (Discrète Cosine Chirp Transform) qui est utilisé comme base de représentation de signaux parcimonieux comme indiqué dans la référence [1].

La figure 9a) illustre la représentation temps fréquence d'un signal OMTDR classique et montre que ce signal est dense dans le plan temps fréquence.

La figure 9b) est un diagramme de la représentation du même signal OMTDR après application d'une transformée DCCT. On peut également remarquer que la répartition des coefficients DCCT est dense et non parcimonieuse.

Enfin, la figure 9c) représente une courbe des modules des coefficients DCCT obtenus à la figure 9b) triés par ordre décroissant On voit que ces coefficients ont une décroissance vers zéro qui est relativement lente. La distribution des coefficients est répartie sur une large plage de valeurs.

Ainsi, un signal OMTDR classique n'est pas parcimonieux et ne peut être compressé dans le domaine DCCT.

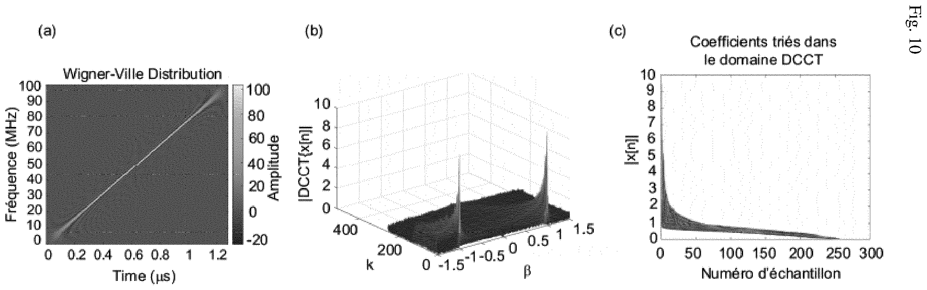

La figure 10 illustre les mêmes diagrammes qu'à la figure 9 mais cette fois pour un signal OMTDR généré à l'aide de l'invention.

La figure 10a) montre que la représentation temps fréquence du signal suit une évolution linéaire.

Les figures 10b) et 10c) montre que la distribution des modules des coefficients DCCT du signal est parcimonieuse, c'est-à-dire qu'un grand nombre des coefficients sont proches de zéro.

Le signal OMTDR généré à l'aide de l'invention est donc compressible dans le domaine DCCT.

Le document [1] décrit en détail une méthode permettant de réduire la fréquence d'échantillonnage d'un convertisseur analogique numérique dans un système de réflectométrie lorsque le signal utilisé est compressible dans le domaine DCCT.

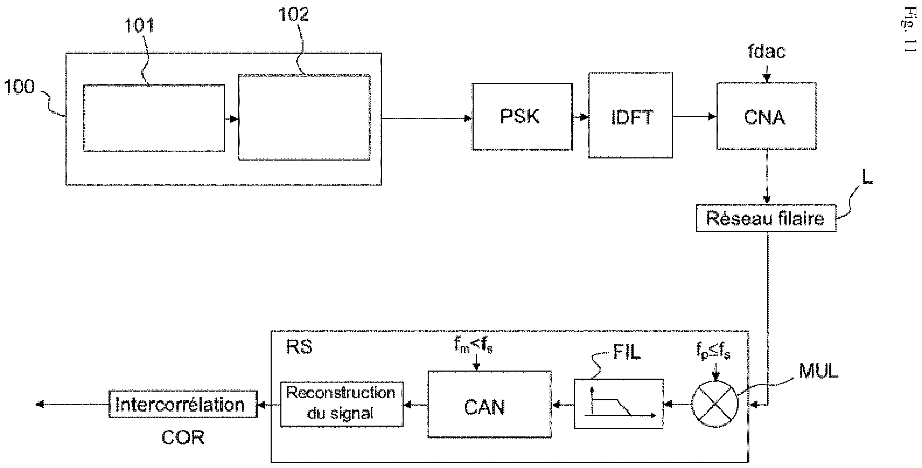

La figure 11 représente un schéma d'un système de réflectométrie 110 selon un second mode de réalisation de l'invention.

Le système 110 comporte un module 100 de génération d'un signal OMTDR selon l'invention comportant au moins un module 101 de génération de phases et un module 102 pour arrondir les phases générées aux symboles les plus proches de la constellation choisie.

Le système 110 comporte ensuite un modulateur MOD, un module de transformée de Fourier inverse IDFT et un convertisseur numérique analogique CNA. Ces trois éléments sont identiques à ceux déjà décrits à la figure 1.

Le système 110 diffère du système de réflectométrie décrit à la figure 1 en ce que le convertisseur analogique numérique CAN est remplacé par un système d'acquisition compressée ACQ qui exploite le caractère parcimonieux du signal OMTDR généré.

Le système ACQ est décrit en détail dans le document [1] auquel l'Homme du métier pourra se référer pour plus d'informations quant à sa mise en oeuvre.

Le système ACQ comporte un multiplieur ou mélangeur MUL qui a pour fonction de multiplier le signal mesuré en sortie de coupleur avec une séquence pseudo-aléatoire de valeurs +/-1. Le mélangeur MUL fonctionne à une fréquence fp

9

qui peut être supérieure à la fréquence de Nyquist fs.

Le système ACQ comporte ensuite un filtre passe bas FIL dont la fréquence de coupure dépend du facteur de compression souhaité puis un convertisseur analogique numérique CAN qui fonctionne à une fréquence d'échantillonnage fm qui est inférieure à la fréquence fp du signal.

Un module RS de reconstruction du signal permet de reconstruire le signal avant de réaliser l'intercorrélation COR avec une copie du signal généré.

Différentes techniques de reconstruction du signal peuvent être mises en oeuvre par le module RS. Un exemple de mise en oeuvre possible consiste à appliquer un algorithme glouton permettant de construire d'une manière itérative une approximation parcimonieuse du signal. Un exemple d'algorithme glouton est l'algorithme « Orthogonal Matching Pursuit » décrit dans la référence [2].

Références

[1] « Ajamian, T. (2019). Exploration of Compressive Sampling for Wire Diagnosis Systems Based on Reflectometry (Doctoral dissertation, École centrale de Nantes) »

[2] Joel A Tropp and Anna C Gilbert, "Signal recovery from random measurements via orthogonal matching pursuit", in: IEEE Transactions on information theory 53.12 (2007), pp. 4655-4666.

**Revendications**

1. Méthode de génération d'un signal de réflectométrie multi-porteuses destiné à être injecté dans une ligne de transmission pour identifier la présence d'au moins un défaut éventuel sur la ligne, la méthode comprenant les étapes de :

   - Générer, dans le domaine fréquentiel, un signal numérique multi-porteuses modulé en phase en :

     i. Générant (501) un signal numérique,
     ii. Modulant (502) le signal numérique en phase à partir d'une constellation de symboles, la phase $\theta_k$ de chaque symbole modulé étant déterminée à partir de l'égalité suivante : $\theta_k = \pm(\alpha * k^2)$, où k est l'indice de chaque porteuse du signal et varie entre 1 et le nombre de porteuses N du signal,

     iii. $\alpha$ est un coefficient pris dans l'intervalle $[\frac{\pi}{N} - \frac{\pi}{2N} ; \frac{\pi}{N} + \frac{\pi}{2N}]$,
     iv. Arrondissant (503) la phase $\theta_k$ obtenue à la phase du symbole de la constellation la plus proche,

   - Convertir (504) le signal généré dans le domaine temporel.

2. Méthode de génération d'un signal de réflectométrie multi-porteuses selon la revendication 1 dans lequel la phase $\theta_k$ de chaque symbole modulé est déterminée à partir de l'égalité suivante : $\theta_k = \pm(\alpha * k^2) + \gamma \frac{\pi}{N} k + \delta$, où $\gamma$ est un entier relatif et $\delta$ est une constante.

3. Méthode de génération d'un signal de réflectométrie multi-porteuses selon l'une quelconque des revendications précédentes dans laquelle la constellation de symboles est une constellation d'une modulation en phase PSK ou d'une modulation en phase et en amplitude QAM.

4. Méthode de génération d'un signal de réflectométrie multi-porteuses selon l'une quelconque des revendications précédentes dans laquelle le signal généré est un signal pseudo-périodique modulé en fréquence de type « chirp ».

5. Méthode de génération d'un signal de réflectométrie multi-porteuses selon l'une quelconque des revendications précédentes comprenant en outre les étapes de :

   - Convertir le signal numérique généré en signal analogique,
   - Injecter le signal analogique dans une ligne de transmission.

**6.** Méthode d'identification de la présence d'au moins un défaut éventuel sur une ligne de transmission, la méthode comprenant les étapes de :

- Générer un signal de réflectométrie multi-porteuses et l'injecter dans une ligne de transmission au moyen de la méthode selon la revendication 5,
- Acquérir et analyser l'écho dudit signal de réflectométrie réfléchi pour en déduire une information relative à la détection et/ou la localisation de discontinuité d'impédance caractéristique d'au moins un défaut.

**7.** Méthode d'identification de la présence d'au moins un défaut selon la revendication 6 dans laquelle l'étape d'analyser l'écho du signal de réflectométrie comprend les sous-étapes de :

- calculer l'intercorrélation entre le signal de réflectométrie réfléchi et le signal de réflectométrie injecté dans la ligne, pour obtenir un réflectogramme,
- analyser le réflectogramme pour identifier au moins un pic d'amplitude caractéristique de la présence d'un défaut sur la ligne.

**8.** Méthode d'identification de la présence d'au moins un défaut selon la revendication 6 dans laquelle l'étape d'analyser l'écho du signal de réflectométrie comprend les sous-étapes de :

- Multiplier le signal de réflectométrie acquis par une séquence pseudo aléatoire,
- Appliquer un filtre passe bas au signal obtenu,
- Convertir le signal filtré numériquement,
- Reconstruire le signal.

**9.** Dispositif de génération (300) d'un signal de réflectométrie destiné à être injecté dans une ligne de transmission pour identifier la présence d'au moins un défaut éventuel sur la ligne, ledit dispositif comprenant des moyens adaptés pour mettre en oeuvre la méthode de génération d'un signal de réflectométrie selon l'une quelconque des revendications 1 à 5.

**10.** Dispositif (110) de génération d'un signal de réflectométrie selon la revendication 9 comprenant un générateur de signal de réflectométrie configuré pour mettre en oeuvre la méthode de génération d'un signal de réflectométrie selon l'une quelconque des revendications 1 à 5, un convertisseur numérique analogique (CNA) et un dispositif de couplage pour injecter le signal de réflectométrie analogique dans une ligne de transmission.

**11.** Programme d'ordinateur comportant des instructions qui conduisent le dispositif selon l'une des revendications 9 ou 10 à exécuter les étapes de la méthode de génération d'un signal de réflectométrie selon l'une quelconque des revendications 1 à 4.

**12.** Support d'enregistrement lisible par un processeur sur lequel est enregistré le programme d'ordinateur selon la revendication 11

**Patentansprüche**

**1.** Verfahren zum Erzeugen eines Mehrträger-Reflektometriesignals, das in eine Übertragungsleitung eingespeist werden soll, um das Vorhandensein mindestens eines möglichen Fehlers in der Leitung zu identifizieren, wobei das Verfahren folgende Schritte umfasst:

- Erzeugen eines digitalen, phasenmodulierten Mehrträgersignals in dem Frequenzbereich, durch:

i. Erzeugen (501) eines digitalen Signals,
ii. Phasenmodulieren (502) des digitalen Signals anhand einer Symbolkonstellation, wobei die Phase $\theta_k$ eines jeden modulierten Symbols anhand der folgenden Gleichung bestimmt wird: $\theta_k = \pm (\alpha * k^2)$, wobei k der Index eines jeden Trägers des Signals ist und zwischen 1 und der Anzahl N der Träger des Signals variiert,

iii. $\alpha$ ein Koeffizient ist, der in dem Intervall $\left[\frac{\pi}{N} - \frac{\pi}{2N} ; \frac{\pi}{N} + \frac{\pi}{2N}\right]$, gewählt ist,
iv. Runden (503) der erzielten Phase $\theta_k$ auf die Phase des Symbols der nächstgelegenen Konstellation,

- Umwandeln (504) des erzeugten Signals in den Zeitbereich.

2. Verfahren zum Erzeugen eines Mehrträger-Reflektometriesignals nach Anspruch 1, wobei die Phase $\theta_k$ eines jeden modulierten Symbols anhand der folgenden Gleichung bestimmt wird: $$\theta_k = \pm(\alpha * k^2) + \gamma \frac{\pi}{N} k + \delta$$ , worin $\gamma$ eine relative Ganzzahl ist und $\delta$ eine Konstante ist.

3. Verfahren zum Erzeugen eines Mehrträger-Reflektometriesignals nach einem der vorhergehenden Ansprüche, wobei die Symbolkonstellation eine Konstellation aus einer Phasenmodulation PSK oder einer Phasen- und Amplitudenmodulation QAM ist.

4. Verfahren zum Erzeugen eines Mehrträger-Reflektometriesignals nach einem der vorhergehenden Ansprüche, wobei das erzeugte Signal ein frequenzmoduliertes pseudoperiodisches Signal vom Typ "chirp" ist.

5. Verfahren zum Erzeugen eines Mehrträger-Reflektometriesignals nach einem der vorhergehenden Ansprüche, ferner folgende Schritte umfassend:

   - Umwandeln des erzeugten digitalen Signals in ein analoges Signal,
   - Einspeisen des analogen Signals in eine Übertragungsleitung.

6. Verfahren zum Identifizieren des Vorhandenseins von mindestens einem möglichen Fehler in einer Übertragungsleitung, wobei das Verfahren folgende Schritte umfasst:

   - Erzeugen eines Mehrträger-Reflektometriesignals und Einspeisen desselben in eine Übertragungsleitung mittels des Verfahrens nach Anspruch 5,
   - Erfassen und Analysieren des Echos des reflektierten Reflektometriesignals, um daraus eine Information bezüglich der Erkennung und/oder des Ortstands einer Impedanzdiskontinuität abzuleiten, die für mindestens einen Fehler charakteristisch ist.

7. Verfahren zum Identifizieren des Vorhandenseins mindestens eines Fehlers nach Anspruch 6, wobei der Schritt des Analysierens des Echos des Reflektometriesignals folgende Teilschritte umfasst:

   - Berechnen der Kreuzkorrelation zwischen dem reflektierten Reflektometriesignal und dem in die Leitung eingespeisten Reflektometriesignal, um ein Reflektogramm zu erzielen,
   - Analysieren des Reflektogramms, um mindestens eine Amplitudenspitze zu identifizieren, die für das Vorhandensein eines Fehlers in der Leitung charakteristisch ist.

8. Verfahren zum Identifizieren des Vorhandenseins mindestens eines Fehlers nach Anspruch 6, wobei der Schritt des Analysierens des Echos des Reflektometriesignals folgende Teilschritte umfasst:

   - Multiplizieren des erfassten Reflektometriesignals mit einer Pseudozufallssequenz,
   - Anwenden eines Tiefpassfilters auf das erzielte Signal,
   - Umwandeln des digital gefilterten Signals,
   - Rekonstruieren des Signals.

9. Vorrichtung (300) zum Erzeugen eines Reflektometriesignals, das dazu bestimmt ist, in eine Übertragungsleitung eingespeist zu werden, um das Vorhandensein mindestens eines möglichen Fehlers in der Leitung zu identifizieren, wobei die Vorrichtung Mittel umfasst, die angepasst sind, um das Verfahren zum Erzeugen eines Reflektometriesignals nach einem der Ansprüche 1 bis 5 durchzuführen.

10. Vorrichtung (110) zum Erzeugen eines Reflektometriesignals nach Anspruch 9, umfassend einen Reflektometriesignalgenerator, der zur Durchführung des Verfahrens zum Erzeugen eines Reflektometriesignals nach einem der Ansprüche 1 bis 5 konfiguriert ist, einen Digital-Analog-Wandler (DAC) und eine Kopplungsvorrichtung zum Einspeisen des analogen Reflektometriesignals in eine Übertragungsleitung.

11. Computerprogramm, umfassend Anweisungen, welche die Vorrichtung nach einem der Anspruch 9 oder 10 dazu veranlassen, die Schritte des Verfahrens zum Erzeugen eines Reflektometriesignals nach einem der Ansprüche 1 bis 4 auszuführen.

**12.** Prozessorlesbarer Aufzeichnungsträger, auf dem das Computerprogramm nach Anspruch 11 aufgezeichnet ist.

**Claims**

**1.** A method for generating a multi-carrier reflectometry signal intended to be injected into a transmission line to identify the presence of at least one possible fault on the line, the method comprising the steps of:

- generating, in the frequency domain, a phase-modulated multi-carrier digital signal by:

  i. generating (501) a digital signal,
  ii. phase-modulating (502) the digital signal based on a constellation of symbols, the phase $\theta_k$ of each modulated symbol being determined based on the following equation: $\theta_k = \pm (\alpha * k^2)$, where k is the index of each carrier of the signal and varies between 1 and the number of carriers N of the signal,

  iii. $\alpha$ is a coefficient within the interval $[\frac{\pi}{N} - \frac{\pi}{2N} ; \frac{\pi}{N} + \frac{\pi}{2N}]$
  iv. rounding (503) the obtained phase $\theta_k$ to the phase of the symbol of the nearest constellation,

- converting (504) the generated signal into the time domain.

**2.** The method for generating a multi-carrier reflectometry signal according to claim 1, wherein the phase $\theta_k$ of each modulated symbol is determined based on the following equation: $\theta_k = \pm(\alpha * k^2) + \gamma \frac{\pi}{N} k + \delta$, where $\gamma$ is a relative integer and $\delta$ is a constant.

**3.** The method for generating a multi-carrier reflectometry signal according to any one of the preceding claims, wherein the constellation of symbols is a constellation of a phase modulation PSK or of a phase and amplitude modulation QAM.

**4.** The method for generating a multi-carrier reflectometry signal according to any one of the preceding claims, wherein the generated signal is a frequency-modulated pseudo-periodic "chirp" signal.

**5.** The method for generating a multi-carrier reflectometry signal according to any one of the preceding claims, further comprising the steps of:

- converting the generated digital signal into an analogue signal,
- injecting the analogue signal into a transmission line.

**6.** A method for identifying the presence of at least one possible fault on a transmission line, the method comprising the steps of:

- generating a multi-carrier reflectometry signal and injecting it into a transmission line by way of the method according to claim 5,
- acquiring and analysing the echo of said reflected reflectometry signal to deduce therefrom a piece of information relating to the detection and/or the location of an impedance discontinuity which is characteristic of at least one fault.

**7.** The method for identifying the presence of at least one fault according to claim 6, wherein the step of analysing the echo of the reflectometry signal comprises the substeps of:

- computing the intercorrelation between the reflected reflectometry signal and the reflectometry signal injected into the line, to obtain a reflectogram,
- analysing the reflectogram to identify at least one amplitude peak which is characteristic of the presence of a fault on the line.

**8.** The method for identifying the presence of at least one fault according to claim 6, wherein the step of analysing the echo of the reflectometry signal comprises the substeps of:

- multiplying the acquired reflectometry signal by a pseudo-random sequence,
- applying a low-pass filter to the obtained signal,
- converting the digitally filtered signal,
- reconstructing the signal.

9. A device (300) for generating a reflectometry signal intended to be injected into a transmission line to identify the presence of at least one possible fault on the line, said device comprising means designed to implement the method for generating a reflectometry signal according to any one of claims 1 to 5.

10. The device (110) for generating a reflectometry signal according to claim 9, comprising a reflectometry signal generator configured to implement the method for generating a reflectometry signal according to any one of claims 1 to 5, a digital-to-analogue converter (DAC) and a coupling device for injecting the analogue reflectometry signal into a transmission line.

11. A computer program comprising instructions which cause the device according to any one of claim 9 or 10 to execute the steps of the method of generating a reflectometry signal according to any one of claims 1 to 4.

12. A processor-readable recording medium on which the computer program according to claim 11 is recorded.

Fig. 1

Fig. 2

Fig. 3

EP 4 160 230 B1

EP 4 160 230 B1

Fig. 4

Fig. 5

Génération signal numérique — 501

Détermination phases — 502

Modulation — 503

IDFT — 504

Fig. 6

Fig. 7

Fig. 8

(a) Wigner-Ville Distribution

(b)

(c) Coefficients triés dans le domaine DCCT

Fig. 9

EP 4 160 230 B1

23

Fig. 10

Fig. 11

## RÉFÉRENCES CITÉES DANS LA DESCRIPTION

**Documents brevets cités dans la description**

- FR 3097971

**Littérature non-brevet citée dans la description**

- **CHRISTOPHE LAYER et al.** Using quadrature modulation for precise fault location over wired communication channels. *2017 15th IEEE International new circuits an systems conférence*
- Exploration of Compressive Sampling for Wire Diagnosis Systems Based on Reflectometry. **AJAMIAN, T.** Doctoral dissertation. École centrale de Nantes, 2019

- **JOEL A TROPP** ; **ANNA C GILBERT**. Signal recovery from random measurementsvia orthogonal matching pursuit. *IEEE Transactions on information theory*, 2007, vol. 53 (12), 4655-4666